Europäisches Patentamt

European Patent Office

Office européen des brevets

(11) Publication number: **0 489 439 A1**

# EUROPEAN PATENT APPLICATION

(21) Application number: **91120906.2**

(22) Date of filing: **05.12.91**

(51) Int. Cl.⁵: **C23C 16/44**, C23C 16/04, C23C 16/00

(30) Priority: **05.12.90 US 622664**

(43) Date of publication of application:
**10.06.92 Bulletin 92/24**

(84) Designated Contracting States:
**DE FR**

(71) Applicant: **APPLIED MATERIALS, INC.**
**3050 Bowers Avenue**
**Santa Clara California 95054(US)**

(72) Inventor: **Cheng, David**
**1235 Valerian Court**
**Sunnyvale, CA 94086(US)**
Inventor: **Chang, Mei**
**963 East Estates Drive**
**Cupertino, CA 95014(US)**

(74) Representative: **Diehl, Hermann Dr. et al**
**Diehl & Glaeser, Hiltl & Partner**
**Flüggenstrasse 13**
**W-8000 München 19(DE)**

(54) **Vacuum deposition apparatus for CVD processing.**

(57) An apparatus for CVD processing is described wherein a wafer (10) mounted on a vertically movable susceptor (40) beneath a gas outlet (20) or showerhead is raised into contact with a shield ring (50) which normally rests on a ring support (70) in the chamber (2). The shield ring (50) engages the frontside edge (11) of the wafer (10), lifting the shield ring (50) off its support (70), when the susceptor (40) and the wafer (10) are raised to a deposition position in the chamber (2). The shield ring (50), by engaging the frontside edge of the wafer (10), shields the edge of the top surface of the wafer (10) as well as the end edge and the backside of the wafer, during the deposition. Matching tapered edges (44, 54) respectively, on the susceptor (40) and the shield ring (50) permit alignment of the shield ring (50). Alignment means (52, 72) are also disclosed to circularly align the shield ring (50) to its support (70) in the chamber (2).

Figure 2

This invention relates to an apparatus for CVD processing of a semiconductor wafer.

In the deposition of materials on a semiconductor wafer during the formation of an integrated circuit structure, it is desirable to exclude deposited materials from the backside of the wafer, as well as the edges of the front surface and the end edges of the wafer. This is of particular importance where the deposited material would not adhere to the native oxides usually present on such surfaces, e.g., due to a lack of prior processing of such surfaces to promote adherence.

For example, when tungsten is deposited over a silicon oxide insulation layer on a semiconductor wafer by CVD processing, the oxide surface must be previously treated before the tungsten being deposited will properly adhere to the surface, e.g., by previous deposition of a titanium tungsten (TiW) or titanium nitride (TiN) material. When tungsten deposits on the edges of the front surface of the wafer, or on the backside of the wafer, (which surfaces have not been pretreated with TiW or TiN) the deposited tungsten does not adhere properly, but rather flakes off as particles which have a deleterious effect on subsequent wafer processing.

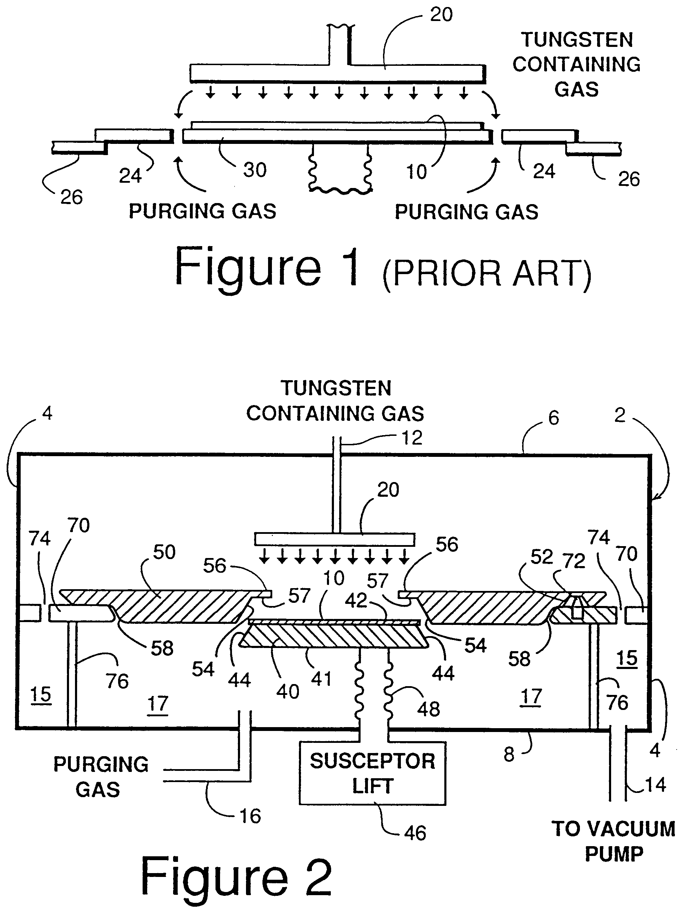

As shown in Figure 1, in prior art deposition apparatus for CVD processing of a wafer, deposition gas or gases, containing a material such as tungsten to be deposited onto the front or top surface of a semiconductor wafer 10, enters the CVD chamber through a gas inlet or "showerhead" 20 which is shown as positioned above wafer 10. A pumping ring 24 is located on a supporting lip or shoulder 26 of the chamber and has an inner diameter (ID) selected, with respect to the outer diameter (OD) of a circular susceptor 30 on which wafer 10 rests, to control the flow therebetween of a nonreactive purging gas from beneath susceptor 30. The purpose of the purging gas flow is to inhibit passage of the deposition gas toward the edge and/or backside of the wafer, i.e., to help prevent unwanted deposition on such surfaces.

Unfortunately, however, it has been found that using such prior art apparatus, materials such as tungsten may still deposit on the frontside edges, end edges, and backside of the semiconductor wafer during deposition by CVD processing.

Studley et al. U.S. Patent 4,932,358 discloses a seal ring which presses against a wafer on a CVD chuck continuously around the outer periphery of the wafer and with sufficient force to hold the backside of the wafer against the chuck. The seal ring has one surface which contacts the front of the wafer and a second surface that extends close to the chuck, so that the edge of the wafer is also excluded from CVD coating. However, a complicated mounting mechanism is required to move the seal ring in and out of clamping engagement with the wafer and to maintain alignment between the seal ring and the wafer.

It would, therefore, be desirable to have an improved vacuum deposition apparatus for CVD processing of a semiconductor wafer, which provides simplified seal ring means which would engage a semiconductor wafer to protect the edges and backside of the wafer from undesirable depositions on such surfaces of the wafer.

This object is solved by the vacuum deposition apparatus for CVD processing according to independent claims 1, 14, or 22. Further advantageous features, aspects and details of the apparatus are evident from the dependent claims, the description and the drawings. The claims are intended to be understood as a first non-limiting approach of defining the invention in general terms.

The invention provides a passive shield for CVD wafer processing which provides frontside edge exclusion and prevents backside depositions. The shield provides frontside edge exclusion of deposited materials on a semiconductor wafer during CVD processing as well as preventing backside depositions.

It is an aspect of this invention to provide shield means which will engage the frontside edge of a semiconductor wafer to inhibit deposition gases from coming into contact with such frontside edge surfaces, as well as the end edge and backside of the wafer, when the susceptor on which the wafer rests is raised to permit the wafer to contact the shield ring to thereby protect such surfaces from undesirable depositions during CVD processing of the wafer.

It is another aspect of this invention to provide shield means comprising a shield ring with a tapered inner edge which will center the wafer, with respect to the shield ring, when the susceptor on which the wafer rests is raised to permit the wafer to contact the shield ring.

It is a further aspect of this invention to provide shield means comprising a shield ring with a tapered inner edge and a susceptor with a matching tapered outer edge which will center the shield ring, with respect to the susceptor, when the susceptor on which the wafer rests is raised to permit the wafer to contact the shield ring.

It is yet a further aspect of this invention to provide shield means which will engage the frontside edge of a semiconductor wafer to protect the frontside edge surfaces, as well as the backside of the wafer, from undesirable depositions during CVD processing of the wafer, and support means in the CVD chamber upon which the shield means rests when not engaged by the wafer.

It is still a further aspect of this invention to provide shield means which will engage the frontside edge of a semiconductor wafer to protect the frontside edge surfaces, as well as the backside of the wafer, from undesirable depositions during CVD processing of the wafer, support means in the CVD chamber upon which the shield means rests when not engaged by the wafer, and alignment means associated with the shield means and the support means to align the shield means both laterally and rotationally with respect to the support means when the shield means rest on the support means.

These and other aspects and details of the invention will be apparent from the following description and accompanying drawings.

Figure 1 is a fragmentary vertical cross-sectional view of prior art apparatus used in the CVD processing of semiconductor wafers.

Figure 2 is a vertical cross-sectional view of CVD processing apparatus constructed in accordance with the invention with the susceptor and a semiconductor wafer thereon shown in a lowered, non-engaged position with the shield ring resting on support means.

Figure 3 is an enlarged fragmentary vertical cross-section of a portion of the apparatus shown in Figure 2, showing the non-engagement of the shield ring by the wafer and susceptor and showing the shield ring resting on support means.

Figure 4 is a bottom view of the shield ring of the invention showing the rotational alignment slot and the alignment pin on the support member in the slot.

Figure 4A is an enlarged fragmentary view of the shield ring of Figure 4, showing the alignment slot and pin therein.

Figure 5 is a vertical cross-sectional view of the CVD processing apparatus of Figure 2 with the susceptor and wafer shown in a raised position of engagement with the shield ring which has been lifted off the support means.

Figure 6 is an enlarged fragmentary vertical cross-section of a portion of the apparatus shown in Figure 5, showing engagement of the shield ring by the wafer and susceptor and showing the shield ring raised off the support means.

Figure 7 is an enlarged fragmentary vertical cross-sectional view of a portion of the apparatus shown in Figure 2 with the wafer shown in an offset or skewed position and being engaged by the tapered edge of the shield ring to urge the wafer back into an aligned position.

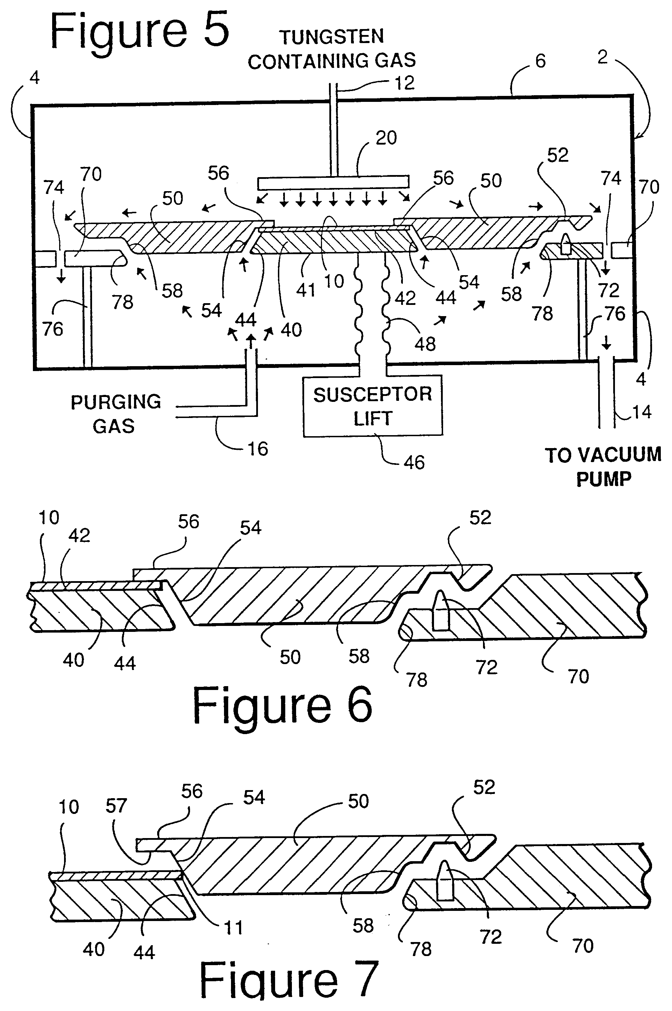

Referring now to Figures 2-6, and in particular to general Figures 2 and 5, a vacuum deposition chamber capable of CVD processing is generally indicated at 2 which contains a wafer 10 mounted on a vertically movable susceptor 40 beneath a gas outlet or showerhead 20 through which process gas enters chamber 2. A shield ring 50, which normally rests on support means 70 in chamber 2, engages the frontside edge of wafer 10 when susceptor 40 and wafer 10 are raised to a deposition position in chamber 2, as shown in Figures 5 and 6. Shield ring 50, by engaging the frontside edge of wafer 10, shields the edge of the top surface of wafer 10, as well as the end edge and the backside of wafer 10, from the deposition as will be explained in more detail below.

Chamber 2 may comprise one chamber of a multiple chamber integrated processing system for performing a number of process steps on a semiconductor wafer in a plurality of interconnected vacuum processing chambers. Such a multi-chamber integrated process system is disclosed and claimed in Maydan et al. U.S. Patent 4,951,601, assigned to the assignee of this invention, and cross-reference to which is hereby made.

Chamber 2 includes sidewalls 4, top wall 6, and bottom wall 8. Process gas entering inlet tube 12 in top wall 6 is discharged into vacuum chamber 2 through showerhead 20 which is positioned above wafer 10. Purging gas enters chamber 2 from an inlet port or tube 16 through bottom wall 8. A vacuum port 14, leading to a vacuum pump, may also be located on bottom wall 8. The support means 70 for shield ring 50 may be operationally connected to sidewalls 4 of chamber 2.

A sleeve or skirt member 76 depends downwardly from support means 70 to bottom wall 8 to divide the bottom portion of chamber 2 into an outer portion 15 in communication with vacuum outlet 14, and an inner portion 17 into which the purge gas flows from inlet 16. Pumping holes or openings 74 in support means 70 permit both process gas and purge gas to enter outer portion 15 from which they are pumped out of chamber 2 via vacuum outlet 14.

Susceptor 40, on which wafer 10 is supported in chamber 2, comprises a disk-like circular metal member having a broad base or bottom surface 41 with a tapered sidewall 44 leading to a narrower top surface 42 which is designed to be approximately equal in diameter to the diameter of wafer 10 at the deposition temperature, e.g., at a temperature ranging from about 200°C to about 700°C.

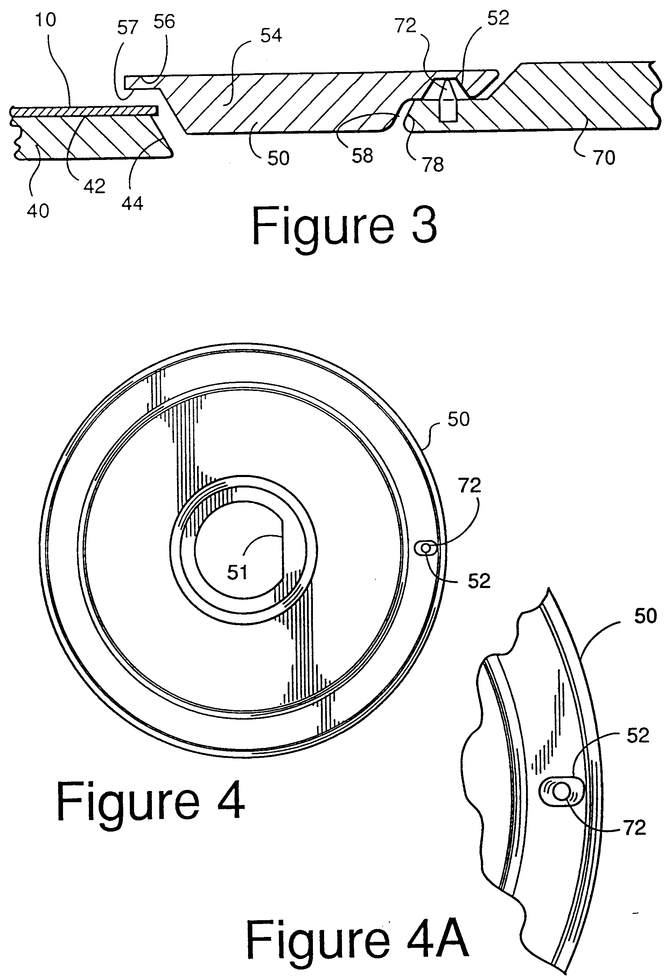

Susceptor 40 is movable vertically within chamber 2 via lift means which may comprise, by way of example and not of limitation, fluid power means 46 and an expandable lift tube means 48 having bellows to permit vertical expansion of tube means 48 when hydraulic or pneumatic fluid is pumped into lift tube means 48 by fluid power means 46. Figure 2 shows lift tube means 48 in a retracted position, resulting in susceptor 40 and wafer 10 thereon being in a lowered position (as seen in both Figures 2 and 3). Figure 5, in contrast, shows lift tube means 48 in an expanded position to raise susceptor 40 and wafer 10 thereon into position below showerhead 20 for CVD processing to deposit the desired material onto the wafer.

In accordance with the invention, when susceptor 40 and wafer 10 thereon are raised to the operating or deposition position, as shown in Figures 5 and 6, the frontside edge (the edge of the top surface) of wafer 10 engages the undersurface of an inner lip 56 of a shield ring 50 and lifts shield ring 50 off support means 70 on which shield ring 50 normally rests when not engaged by wafer 10.

Shield ring 50, as seen in the top view of Figure 4, is generally circular or doughnut shaped, having a generally circular central opening with a flat edge 51 on one side of the central opening corresponding to the conventional orientation flat found on semiconductor wafers.

Shield ring 50 may be formed of a metal such as aluminum, stainless steel, nickel, monel, or any other metal which would be compatible with other materials used in the construction of the deposition apparatus, i.e., the walls, the susceptor, the showerhead, etc. which are all conventionally made of aluminum or stainless steel. Preferably, however, shield ring 50 will be constructed of a non-metallic material which: (1) will be compatible with the operating temperature employed during the processing, (2) will be compatible with the vacuum conditions in the chamber, i.e., will not outgas, and (3) will be chemically inert, i.e., nonreactive, with the materials used in the deposition process.

Since materials used in the deposition process may also deposit on the shield ring, necessitating cleaning of the ring, shield ring 50, in the preferred embodiment, should be constructed of a ceramic material such as, for example, aluminum oxide, magnesium oxide, silicon nitride, boron nitride, zirconium oxide, magnesium fluoride, or quartz. Shield ring 50 could also be constructed of a base material, e.g., aluminum, and then coated or clad with a covering of a non-metallic material meeting the above criteria, such as the above described ceramic materials, or an anodized coating of the base metal, e.g. a coating of aluminum oxide formed on an aluminum shield ring by anodizing it.

The central opening of shield ring 50 is provided with a tapered inner edge 54 on the lower surface of ring 50 having approximately the same angle of taper as tapered outer edge 44 on susceptor 40, i.e., a matching taper. Tapered inner edge 54 terminates, at its upper end, at inner lip 56. Inner lip 56, in turn, is dimensioned to inwardly extend circumferentially from tapered inner edge 54 a predetermined distance to extend over the frontside edge of wafer 10. Inner lip 56 has an undersurface 57 which is flat and parallel to the surface of wafer 10 to permit flat contact therebetween to provide a seal to inhibit passage of process gas therebetween.

The minimum amount or extent of coverage of the frontside or top surface edge of wafer 10 by inner lip 56 of shield ring 50 will be an amount sufficient to at least provide a seal therebetween which will prevent process gases from reaching the end edge and rear surface of wafer 10. The actual amount of coverage of the front side edge of wafer 10 by inner lip 56 of shield 50 will be further governed, at least in some deposition processes, by the extent of coverage of the top surface of wafer 10 by previous processing steps. For example, when depositing tungsten on a silicon oxide surface of wafer 10, i.e., either the oxide-coated surface of the substrate itself or an oxide coating on previously formed epitaxial silicon or polysilicon surfaces, the silicon oxide must be pretreated with another material, e.g., TiW or TiN, to provide proper adherence of the tungsten layer, i.e., to prevent particles of tungsten from flaking off. If such a pretreatment step did not extend to the end edge of the wafer, then the area not so pretreated must be covered by inner lip 56 of shield ring 50 to prevent deposition and resultant particle formation on such unprotected surfaces. The inner lip will, therefore, usually be dimensioned to extend inwardly over the front side edge of the wafer a distance of from about 1.5 to about 6 millimeters (mm.), typically about 5 mm., to provide the desired sealing and front side edge shielding.

The ID of the top portion of tapered inner edge 54 on shield ring 50 is just slightly larger than the OD of top surface 42 of susceptor 40, i.e., by about a millimeter, while the ID of shield ring 50 at the bottom of tapered inner edge 54 is larger than the OD of base 41 of susceptor 40 by approximately the same amount. This tolerance is provided for at least two reasons. First, the tolerance is provided to compensate for possible differences in thermal expansion when different materials are respectively used in constructing susceptor 40 and shield ring 50. The tolerance is also provided to ensure that as susceptor 40 and wafer 10 thereon are lifted into contact with shield ring 50, shield ring 50 will not be supported by contact between tapered inner edge 54 of shield ring 50 and tapered outer edge 44 of susceptor 40, but rather by contact of the underside of inner lip 56 with the top surface of wafer 10 to enhance the sealing therebetween.

By tapering the outer edge 44 of susceptor 40 and the inner edge 54 of shield ring 50 by the same angle, an angle which will usually be about 30°, but which may vary from about 15° to about 60°, i.e., by providing matching tapers, any possible misalignment of shield ring 50, with respect to susceptor 40 (and wafer 10 thereon), may be corrected by contact between the respective tapered surfaces which will cause shield ring 50 to laterally shift or slide back into alignment with susceptor 40.

The tapered edge 54 of shield ring 50 serves an additional function in the potential lateral alignment of wafer 10, should wafer 10 not be positioned on susceptor 40 in coaxially alignment therewith. As seen in Figure 7, when wafer 10 is misaligned with respect to susceptor 40, the edge 11 of wafer 10 extending beyond top surface 42 of susceptor 40 will come into contact with tapered edge 54 of shield ring 50 as susceptor 40 and wafer 10 are raised into position. The relative light weight of wafer 10, with respect to the weight of shield ring 50, will cause wafer 10 to shift laterally to realign wafer 10 with susceptor 40 as susceptor 40 and wafer 10 thereon continue to rise.

Shield ring 50 is supported in chamber 2, when not in engagement with susceptor 40 and wafer 10, by resting on a support means 70 which may comprise a circular shoulder or support bracket secured to sidewall 4 of chamber 2. Alternatively support means 70 may itself comprise a ring which is, in turn, supported by a rigid support secured to sidewall 4 of chamber 2.

In a preferred embodiment, shield ring 50 is maintained in rotational alignment with support means 70 by alignment means carried on the under surface of shield ring 50 and the upper surface of support means 70 which interact when susceptor 40 and wafer 10 are lowered out of engagement with shield ring 50, i.e., the position shown in Figures 2 and 3. As shown in those figures (as well as in Figures 4, 4A, 5 and 6), the alignment means may comprise a beveled or tapered pin 72 on the upper surface of support means 70 which is received in a similarly beveled or tapered slot opening 52 which is formed in the undersurface of shield ring 50 and which extends radially outward. As shield ring 50 is lowered onto support means 70, if shield ring 50 is rotationally misaligned, with respect to support means 70, the respective beveled side edges of pin 72 and opening 52 will contact one another and move shield ring 50 back into rotational alignment so that the flat portion 51 maintains the same orientation.

Shield ring 50 may also be provided with a tapered outer surface or edge 58 along at least the lower portion of the outer edge of ring 50 which matches a similarly tapered inner edge 78 provided on support means 70. When shield ring 50 has been raised off support means 70 by susceptor 40, tapered edges 58 and 78 cooperate to provide a passageway for purging gas or gases, i.e., nonreactive gases such as argon, helium or the like, to pass through from below wafer 10 in chamber 2, as shown in Figure 5. Such purging gases act to confine the process or deposition gases in chamber 2 to the volume above wafer 10 to facilitate the deposition thereon and to inhibit undesired deposits elsewhere in chamber 2.

It should be further mentioned, in this regard, that while the purging gas does not usually pass between the end edge of wafer 10 and the inner edges of shield ring 50 in the structure of the invention, should there be any passageway or opening between the wafer and the shield ring,, i.e., should an incomplete seal be formed between the frontside edge of wafer 10 and undersurface 57 of lip 56 of shield ring 50, the purging gas will pass through such openings, thereby inhibiting the undesirable passage of process gases through such openings to the shielded portions of wafer 10, i.e., to the frontside edge, end edge, and backside of wafer 10.

Thus, the invention provides means for preventing or inhibiting undesirable deposition of materials on the frontside edge, end edge, and backside of a semiconductor wafer during CVD processing comprising a shield ring in the deposition chamber which is engaged by the top surface of the wafer as the susceptor and wafer thereon are raised into a deposition position. Matching tapered surfaces respectively on the susceptor and the shield ring permit alignment of the shield ring with respect to the susceptor as well as permitting the wafer to be aligned to the shield ring. Alignment means on the shield ring and a support means used to support the shield ring when not engaged by the wafer, permit alignment of the shield ring with respect to the support means. Matching tapered surfaces on the shield ring and the support means provide a purging gas passageway when the shield ring is raised off the support means by the wafer.

## Claims

1.  A vacuum deposition apparatus for CVD processing of a semiconductor wafer (10) which comprises:

    a) a vacuum deposition chamber (2);

    b) wafer support means comprising a susceptor (40) in said chamber (2);

    c) a generally circular semiconductor wafer (10) on said susceptor (40);

    d) process gas inlet means (20) in said chamber (2);

    e) means (46, 48) for vertically moving said susceptor (40) and wafer (10) thereon upwardly and downwardly in said chamber (2); and

    f) shield means (50) in said chamber (2) engageable by the frontside edge (11) of said wafer (10) when said wafer (10) and susceptor (40) are vertically moved upward to shield said frontside edge (11) of said wafer (10) during CVD processing to prevent deposition on said frontside edge (11) of said wafer (10).

2. The apparatus of claim 1 wherein said susceptor (40) is circular and is provided with an outer edge (44) which is inwardly tapered from a larger bottom surface (41) to a top surface (42) which is approximately the same diameter as said wafer (10); and said shield means (50) comprises a circular shield ring having a tapered circular inner edge (54) extending inwardly from the bottom surface of said ring to the bottom surface (57) of a lip (56) on said shield ring which extends inwardly to engage the frontside edge (11) of said wafer (10).

3. The apparatus of claim 2 wherein said tapered outer edge (44) of said susceptor (40) is of smaller dimension than said tapered inner edge (54) of said shield ring (50) and the angle of taper of said susceptor outer edge (44) and of said shield ring inner edge (54) are approximately equal, whereby said shield ring (50) may be laterally moved into alignment with said susceptor (40) by contact between said respective tapered edges as said susceptor (40) and said wafer (10) thereon are raised into engagement with said shield ring (50).

4. The apparatus of claim 2 or 3 wherein the diameter of the upper surface (42) of said circular susceptor (40) is approximately equal to the diameter of said wafer (10) whereby said tapered inner edge (54) of said shield ring (50) will engage a portion of the end edge (11) of said wafer (10) during the raising of said susceptor (40), and said wafer (10) thereon if said wafer (10) is axially misaligned with respect to said susceptor (40) and said tapered inner edge (54) of said shield ring (50) will urge said wafer (10) back into an aligned position with respect to said susceptor (40).

5. The apparatus of one of claims 2 to 4 wherein said tapered outer edge (44) of said susceptor (40) and said tapered inner edge (54) of said shield ring (50) each define an angle ranging from about 15° to about 60° with respect to the vertical.

6. The apparatus of one of claims 2 to 5 wherein the under surface (57) of said inner lip (56) of said shield ring (50) is parallel to the surface of said wafer (10) and said inner lip (56) extends inwardly over said frontside edge of said wafer (10) a distance ranging from about 1.5 to about 6 millimeters.

7. The apparatus of one of claims 2 to 6 wherein said shield ring (50) is supported in said chamber (2) by shield ring support means (70) operationally attached to said chamber (2) which permit vertical upward movement of said shield ring (50) off said ring support means (70) as said susceptor (40) and said wafer (10) thereon are vertically moved upward into engagement with the undersurface (57) of said lip (56) on said shield ring (50).

8. The apparatus of one of claims 2 to 7 wherein alignment means (52, 72) are carried by said shield ring (50) and said ring support means (70) to circularly align said shield ring (50) to said ring support means (70).

9. The apparatus of claim 8 wherein said alignment means (52, 72) comprise mating means respectively carried on the undersurface of said shield ring (50) and the upper surface of said ring support means (70).

10. The apparatus of claim 9 wherein said mating means comprise a pin (72) with a tapered head and a slot (52) extending radially on said under surface of said shield ring (50) with correspondingly tapered sidewalls to receive said tapered pin (72).

11. The apparatus of one of claims 2 to 10 wherein said shield ring (50) has an outer tapered edge (58) which mates with a tapered surface (78) on ring support means (70) to provide a purging gas passage therebetween when said shield ring (50) is lifted off said ring support means (70) by said susceptor (40) and said wafer (10), whereby purging gas introduced (16) into said chamber (2) below said wafer (10) may pass through said purging gas passage into the upper portion of said chamber (2).

12. The apparatus of claim 11 wherein a skirt (76) depends downwardly from said shield ring support means (70) to the bottom wall (8) of said chamber (2) to divide that part of said chamber (2) below said shield ring support means (70) into an inner portion (17) in communication with a purge gas inlet (16) and an outer portion (15) in communication with a vacuum outlet (14).

13. The apparatus of one of claims 7 to 12 wherein openings (74) in said shield ring support means (70) permit process gas and purge gas to flow into said outer portion (15) of said chamber (2) and to be evacuated from said chamber (2) through said vacuum outlet (14).

14. A vacuum deposition apparatus for CVD processing of a semiconductor wafer especially according to one of the preceding claims which comprises:

a) a vacuum deposition chamber (2);

b) a generally circular semiconductor wafer (10) in said chamber;

c) wafer support means in said chamber comprising a generally circular susceptor (40) with an outer edge (44) which is inwardly tapered from a larger bottom surface (41) to a top surface (42) which is approximately the same diameter as said wafer (10);

d) process gas inlet means (20) above said wafer (10) on said susceptor (40).

e) means (46, 48) for vertically moving said susceptor (40) and wafer (10) thereon toward and away from said gas inlet means (20); and

f) shield means in said chamber (2) comprising a circular shield ring (50) having a tapered circular inner edge (54) with a taper angle approximately equal to the angle of said tapered outer edge (44) of said susceptor (40), said tapered inner edge (54) of said shield ring (50) extending inwardly from the bottom surface of said ring to the bottom surface (57) of a lip (56) on said shield ring (50) which extends inwardly to engage the frontside edge of said wafer (10) when said wafer (10) and susceptor (40) are vertically moved toward said process gas inlet means (20) to shield said frontside edge of said wafer during CVD processing to prevent deposition on said frontside edge of said wafer;

said tapered outer edge (44) of said susceptor (40) and said tapered inner edge (54) of said shield ring (50) cooperating to provide alignment of said shield ring (50) with respect to said susceptor (40) and to permit alignment of said wafer (10) on said susceptor (40) to said susceptor (40) and said shield ring (50).

15. The apparatus of claim 14 wherein said tapered outer edge (44) of said susceptor (40) is of smaller dimension that said tapered inner edge (57) of said shield ring (50) whereby said shield ring (50) may be laterally moved into alignment with said susceptor (40) by contact between said respective tapered edges as said susceptor (40) and said wafer (10) thereon are raised into engagement with said shield ring (50).

16. The apparatus of claim 14 or 15 wherein said tapered outer edge (44) of said susceptor (40) and said tapered inner edge (54) of said shield ring (50) each define an angle ranging from about 15° to about 60° with respect to the vertical.

17. The apparatus of one of claims 14 to 16 wherein the under surface (57) of said inner lip (56) of said shield ring (50) is parallel to the surface of said wafer (10) and said inner lip (56) extends inwardly over said frontside edge (11) of said wafer (10) a distance ranging from about 1.5 to about 6 millimeters.

18. The apparatus of one of claims 14 to 17 wherein said shield ring (50) is supported in said chamber (2) by ring support means (70) operationally attached to said chamber (2) which permit vertical upward movement of said shield ring (50) off said ring support means (70) as said susceptor (40) and said wafer (10) thereon are vertically moved upward into engagement with the undersurface (57) of said lip (56) on said shield ring (50).

19. The apparatus of claim 18 wherein alignment means comprising mating means (52, 72) are respectively carried on the undersurface (52) of said shield ring (50) and the upper surface of said ring support means (70) to circularly align said shield ring (50) to said ring support means (70).

20. The apparatus of claim 19 wherein said mating means comprise a pin (72) with a tapered head and a correspondingly tapered slot (52) to receive said tapered pin (72).

21. The apparatus of one of claims 14 to 20 wherein said shield ring (50) has an outer tapered edge (58) which mates with a tapered surface (78) on said ring support means (70) to provide a purging gas passage therebetween when said shield ring (50) is lifted off said ring support means (70) by said susceptor (40) and said wafer (10), whereby purging gas introduced into said chamber (2) below said wafer (10) may pass through said purging gas passage into the upper portion of said chamber (2).

22. A vacuum deposition apparatus for CVD processing of a semiconductor wafer especially according to one of the preceding claims which comprises:

a) a vacuum deposition chamber (2);

b) a generally circular semiconductor wafer (10) in said chamber (2);

c) wafer support means in said chamber comprising a generally circular susceptor (40) with an outer edge (44) which is inwardly tapered to define an angle ranging from about 15° to about 60° to the plane of said susceptor (40) from a larger bottom surface (41) to a top surface (42) which is approximately the same diameter as said wafer;

d) process gas inlet means (20) above said wafer (10) on said susceptor (40);

e) means (46, 48) for vertically moving said susceptor (40) and wafer (10) thereon toward and away from said gas inlet means (20);

f) shield means in said chamber comprising a circular shield ring (50) having a tapered circular inner edge (54) of slightly larger dimension than said tapered outer edge (44) of said susceptor (40), with a taper angle approximately equal to said angle of said tapered outer edge (44) of said susceptor (40) to provide matching tapers to permit alignment of said shield ring (50) with respect to said susceptor (40) and alignment of said wafer (10) to said susceptor (40) and said shield ring (50), said tapered inner edge (54) of said shield ring (50) extending inwardly from the bottom surface of said ring to the bottom surface (57) of a lip (56) on said shield ring (50) which extends inwardly to engage from about 1.5 to about 6 mm of the frontside edge (11) of said wafer (10) when said susceptor (40) and wafer (10) are vertically moved toward said process gas inlet means (20) to shield said frontside edge of said wafer during CVD processing to prevent deposition on said frontside edge of said wafer, as well as the end edge and backside of said wafer;

g) shield ring support means (70) operationally attached to said chamber (2) to support said shield ring (50) and to permit vertical upward movement of said shield ring (50) off said ring support means (70) as said susceptor (40) and said wafer (10) thereon are vertically moved upward into engagement with the undersurface (57) of said lip (56) on said shield ring (50); and

h) alignment means comprising mating means (52, 72) respectively carried on the undersurface of said shield ring (50) and the upper surface of said ring support means (70) to circularly align said shield ring (50) to said ring support means (70).

TUNGSTEN
CONTAINING
GAS

20

↓↓↓↓↓↓↓↓↓↓

24    30    10    24    26

26

26

PURGING GAS          PURGING GAS

# Figure 1 (PRIOR ART)

TUNGSTEN
CONTAINING GAS

4          6    2

12

20

74  70

50    56    56

74  70

57

10  57

52  72

42

74

58

54  41

54

58

44  40

44

15

15    17

17

76

76

15

PURGING
GAS

SUSCEPTOR
LIFT

8

16

46

TO VACUUM
PUMP

14

4

48

# Figure 2

Figure 3

Figure 4

Figure 4A

EP 0 489 439 A1

# Figure 5

TUNGSTEN
CONTAINING GAS

12

4

6

2

20

56  50  52

74  70

56  50

74  70

58  54  41 10  42  44  54  58  78

78

72

76

44  40  48  76

14

PURGING
GAS

16

SUSCEPTOR
LIFT

46

TO VACUUM
PUMP

# Figure 6

10 42  56  54  52

40  44  50  58  78  72  70

# Figure 7

10 57  56  54  50  52

40  44  11  58  78  72  70

11

## DOCUMENTS CONSIDERED TO BE RELEVANT

EP 91120906.2

| Category | Citation of document with indication, where appropriate, of relevant passages | Relevant to claim | CLASSIFICATION OF THE APPLICATION (Int. Cl.5) |
|---|---|---|---|
| P,A | US - A - 4 990 374 (JOSEPH T. KEELEY et al.) * Abstract; fig. 3; claims 1-16 * | 1-22 | C 23 C 16/44 C 23 C 16/04 C 23 C 16/00 |
| A | US - A - 4 963 393 (JITENDRA S. GOELA et al.) * Abstract; fig. 2; claims 1-3 * | 1-22 | |
| A | US - A - 4 962 727 (SHIGERU HARADA) * Abstract; fig. 1,3; claims 1-5 * | 1-22 | |
| A | GB - A - 2 196 019 (CAMBRIDGE INSTRUMENTS) * Abstract; fig.; claims 10-13 * | 1-22 | |

TECHNICAL FIELDS SEARCHED (Int. Cl.5)

C 23 C

The present search report has been drawn up for all claims

| Place of search | Date of completion of the search | Examiner |
|---|---|---|
| VIENNA | 03-03-1992 | HAUK |

EPO FORM 1503 03.82 (P0401)